# EUROPEAN PATENT APPLICATION

(11) **EP 4 443 511 A1**
(43) Date of publication of application: **09.10.2024**
(21) Application number: 23167098.5
(22) Date of filing: 06.04.2023
(51) Int. Cl.: H01L 29/06, H01L 29/40, H01L 29/78, H01L 21/336

(54) **SEMICONDUCTOR DEVICE AND METHOD OF FABRICATING A SEMICONDUCTOR DEVICE**

(71) Applicant: Infineon Technologies Austria AG, 9500 Villach (AT)
(72) Inventor: HUTZLER, Michael, 9500 Villach (AT); SIEMIENIEC, Thomas Ralf, 9500 Villach (AT); BREYMESSER, Alexander, 9500 Villach (AT)
(74) Representative: JENSEN & SON

(57) **Abstract**

In an exemplary embodiment, a semiconductor device comprises a semiconductor substrate having a first major surface, one or more trenches formed in the first major surface and having a base and a side wall extending from the base to the first major surface and a conductive member arranged in at least one trench of the one or more trenches. The conductive member is spaced apart from the base of the at least one trench by a lower isolating member and from the side wall of the at least one trench by an enclosed cavity located in the at least one trench. The conductive member has a lower face. A peripheral edge of the lower face of the conductive member is located in the cavity and a central portion of the lower face is in contact with the lower isolating member.

## Description

### BACKGROUND

Conducting structures integrated into semiconductor devices may be electrically insulated from other parts of the device to ensure reliable functioning of the semiconductor device. Examples of such conducting structures are field electrodes and gate electrodes which are insulated from the semiconductor substrate by insulation layers such as oxide layers. As comparably high voltages may occur between field electrodes and the semiconductor substrate during operation of the semiconductor device, the insulation layer needs to be thick to prevent electrical breakdown. However, thick insulation layers need more space and increase the size of the device.

US 2017/0338338 A1 describes a power semiconductor that includes a semiconductor substrate having a drift region, at least one gate electrode trench in the semiconductor substrate and at least one field electrode needle trench in the semiconductor substrate. The field electrode needle trench is laterally spaced from the gate electrode trench and extends into the drift region. A field electrode is arranged in the at least one field electrode needle trench and is electrically insulated from the drift region by a cavity that is formed in field electrode needle trench between the field electrode and the drift region.

Further improvements to semiconductor devices are desirable to further reduce the risk of undesirable electrical breakdown.

### SUMMARY

In an exemplary embodiment, a semiconductor device comprises a semiconductor substrate having a first major surface, one or more trenches formed in the first major surface and having a base and a side wall extending from the base to the first major surface and a conductive member arranged in at least one trench of the one or more trenches. The conductive member is spaced apart from the base of the at least one trench by a lower isolating member and from the side wall of the at least one trench by an enclosed cavity located in the at least one trench. The conductive member has a lower face. A peripheral edge of the lower face of the conductive member is located in the cavity and a central portion of the lower face is in contact with the lower isolating member.

The enclosed cavity is a sealed empty space or void which may comprise a vacuum or a gas or gases, for example the process environment present when the cavity was sealed. The enclosed cavity and the lower electrically isolating member together electrically insulate the electrically conductive member arranged in the trench from the semiconductor substrate. The lower isolating member mechanically supports the lower end of the conductive member within the trench. The peripheral edge of the lower face of the conductive member is exposed from the lower isolating member and is positioned in contact with the cavity. The portion of the lower face of the conductive member that is exposed from the lower isolating member forms a part of the surface defining the enclosed cavity. This combination of the cavity and lower isolating member provides an improved breakdown voltage and improved electromechanical stability of the conductive member.

In some embodiments, the peripheral edge of the conductive member has a rounded or curved contour. The entire curved contour of the peripheral edge is located in the empty cavity and is not in contact with the lower isolating member.

In some embodiments, the lower surface of the conductive member has a rounded contour.

In some embodiments, the conductive member has a side face that extends from the lower face in the direction of the first major surface and, in some embodiments, the side face extends to the first major surface such that an upper face of the conductive member, that opposes the lower face, is substantially coplanar with the first major surface of the semiconductor substrate. In some embodiments, the side face of the conductive member is positioned substantially perpendicularly to the first major surface of the semiconductor substrate and substantially perpendicularly to the lower face of the conductive member.

In some embodiments, the lower isolating member has an upper face, a lower face opposing the upper face and a side face that extends between the upper and lower face. In some embodiments, the side face extends substantially perpendicularly to the upper and lower faces. The lower face is in contact with the base of the trench and the upper face is in contact with the central portion of the lower face of the conductive member. The side face forms a part of the surface defining the enclosed cavity.

In some embodiments, the upper surface of the lower isolating member is in contact with the lower face of the conductive member, for example the central region of the lower face. The isolating member provides a support pillar that is arranged intermediate the area of the lower face of the conductive member and the area of the trench base.

In some embodiments, the upper surface of the lower isolating member is in contact with the lower face of the conductive member and the isolating member provides a support pillar that is arranged intermediate the area of the lower face of the conductive member and intermediate the area of the trench base. The upper face of the lower isolating member is spaced apart from the peripheral edge of the conductive member by a portion of the cavity.

In some embodiments, a peripheral ring of the lower face of the conductive member and a peripheral ring of the base of the trench are exposed from the material of the lower isolating member and form a part of the surface defining the cavity.

In some embodiments, the conductive member protrudes outwardly from the upper surface of the lower isolating member in directions parallel to the first major surface.

In some embodiments, the lower isolating member has a side face and the conductive member has a side face, wherein the minimum spacing, D₁, between the side face of the lower isolating member and the side wall of the at least one trench is greater than the maximum spacing, D₂, between the side face of the conductive member and the side wall of the at least one trench. The spacings D₁ and D₂ are measured in a plane that is parallel to the first major surface and measured between a side face of the conductive member or lower isolating member, respectively, that faces towards the side wall of the trench and is spaced apart from this side wall of the trench by the cavity.

The relationship that D₁ is greater than D₂ means that the difference between D₁ and D₂ is larger than that arising from process variations. In some embodiments, D₁ > 1.1 D₂ and consequently greater than variations resulting from the processing factors or the difference is even greater so that 1.15D₂ ≤ D₁ ≤ 1.6D₂.

In some embodiments, the isolating member has a height H from its lower surface to its upper surface so that the lower face of the conductive member is spaced part from the base of the trench by the height H.

In some embodiments, the height of the isolating member H is substantially the same as the minimum spacing D₂ between the side face of the conductive member and the side wall of the trench. The conductive member is, therefore, spaced apart from the semiconductor substrate on its side and lower faces by substantially the same distance. In some embodiments, H and D₂ are the same within process variations so that 0.9 D₂ ≤ H ≤ 1.1D₂. In some embodiments, the isolating member has a height that is greater than the spacing between the side face of the conductive member and the side face of the trench so that H > 1.1D₂ and consequently greater than variations resulting from the processing conditions. In some embodiments, the difference is even greater so that 1.15D₂ ≤ H ≤ 1.6D₂.

In some embodiments, the conductive member comprises a first maximum width W₁₁ and the isolating member has a second maximum width W₂, so that W₂ < W₁. The dimension of width is measure in a plane that is parallel to the first major surface. In some embodiments, the difference between W₁ and W₂, (W₁-W₂)/W₁×100, is at least 10%. In some embodiments (W₁-W₂)/W₁×100 lies within between 15% and 60%. The relationship between W₁ and W₂ may be selected such that at least the peripheral edge or a peripheral ring of the lower face of the conductive member is exposed from the lower isolating member and such that the lower face of the conductive member is sufficiently mechanically supported by the lower isolating member.

In some embodiments, the spacing between the side face of the conductive member and the sidewall of the at least one of the trenches is greater in a first portion of the at least one trench than in a second portion of the at least one trench. In other words, the cavity has a nonuniform width. The first portion may have a height h₁ and the second portion may each have a height h₂. h₁ and h₂ may be between 25% and 75% of the total height h_{fp} of the conductive member, whereby h_{fp} = h₁ + h₂. The dimension of height is measured in a plane that is perpendicular to the first major surface.

In some embodiments, the second portion of the trench which has a smaller spacing between the side face of the conductive member and the sidewall of the trench is arranged towards the top of the trench and the first portion is arranged towards the lower end of the trench. The second portion may extend to the first major surface of the semiconductor substrate and the first portion may extend to the lower face of the conductive member.

In some embodiments, the spacing between the side face of the conductive member and the facing side wall of the trench may increase continuously so that the side face of the conductive member is arranged at an inclined angle, i.e. less than 90°, for example less than 80°, to the first major surface. The conductive member can be considered to have a tapering shape that is wider towards the top than towards the bottom of the trench.

In some embodiments, the side face of the conductive member comprises a step such that an upper portion of the conductive member has a width a₁ that is greater than a width a₂ of a lower portion of the conductive member and such that an upper portion of the cavity has a width D₂ᵤₚₚₑᵣ that is smaller than a width D_{2lower} of a lower portion of the cavity. In some embodiments, a₁ ≥ 1.1 a₂ and D_{2lower} ≥ 1.1 D₂ᵤₚₚₑᵣ and greater than process variations or the step has a larger width (larger tread) so that 1.15a₂ ≥ a₁ ≤ 1.6 a₂ and 1.15 D₂ᵤₚₚₑᵣ ≤ D_{2lower} ≤ 1.6 D₂ᵤₚₚₑᵣ. D_{2lower} is less than D₁ by an amount that is greater than the process variations such that the peripheral edge and in some embodiments, a ring-shaped peripheral region formed between the lower face and side face of the conductive member is uncovered by the isolating member and positioned in the cavity.

In some embodiments the step is positioned at a height h₁ from the lower face of the conductive member. In some embodiments, the step is positioned at a depth h₂ from the first major surface 12 of the semiconductor substrate. When the first portion has a height h₁ and the second portion has a height h₂ and the conductive member has a total height h_{fp}, whereby h_{fp} = h₁ + h₂, the step may be positioned at a height h₁ from the lower face that is between 25% and 75% of the total height h_{fp} of the conductive member and at a depth h₂ from the first major surface that is between 25% and 75% of the total height h_{fp} of the conductive member.

The step may also be described as a ledge or overhang that protrudes laterally from the lower portion and that is positioned in and forms a part of the wall defining the enclosed cavity.

In some embodiments, the side face of the conductive member comprises more than one step and the width of the cavity increases stepwise from the top to the bottom of the trench.

In some embodiments, the side face of the upper portion and the side face of the lower portion extends substantially perpendicularly to the first major surface of the semiconductor substrate.

In some embodiments, the semiconductor device further comprises a sealing layer that extends between the side wall of the at least one trench and the side face of the conductive member. The sealing layer seals the gap formed in the trench between the column formed by the conductive member and lower isolating member and the respective side wall of trench so as to form an enclosed and sealed cavity or void within the trench. The sealing layer may comprise silicon dioxide or silicon nitride. In some embodiments, the sealing layer comprises two or more sublayers which may be formed of silicon nitride or silicon dioxide, for example a sublayer of silicon nitride on the first major surface and a sublayer of silicon dioxide.

In some embodiments, the at least one trench is an elongate stripe trench. An elongate trench has a length in a plane parallel to the first major surface that is greater than its depth in the substrate, that is its depth perpendicular to the first major surface. A plurality of elongate stripe-like trenches may be provided that extend substantially parallel to one another.

An elongate strip-like trench may be substantially rectangular in plan view so that the side wall of the trench comprises four side wall sections, whereby adjoining side wall sections are arranged substantially perpendicularly to one another.

In some embodiments, the at least one trench is a columnar trench. A columnar trench may also be called a needle trench or a specular trench. A columnar trench has a small or narrow circumference or width in proportion to its height / depth in the substrate, that is its height/depth perpendicular to the first major surface. A columnar trench may have an octagonal, circular, square, hexagonal and shape in plan view. The shape in plan view of the columnar trench may be the same as of different from the shape in plan view of the field plate. For example, a circular field plate may be arranged in a hexagonal trench. The columnar trenches and consequently the field plate positioned in the trench may be arranged in a regular square grid array of rows and columns, or an offset rows or a hexagonal array, for example.

If the columnar trench is circular in plan view it has a single continuous side wall. If the columnar trench has a square or hexagonal or octagonal shape in plan view, the side wall comprises four or six or eight side wall sections, respectively, that extend at an angle to one another.

In some embodiments, the conductive member within the trench may be used to provide a transistor or the plate of a capacitor.

In some embodiments, the conductive member is used as a field plate in a transistor device. In some embodiments, the semiconductor substrate comprises a first conductivity type and a plurality of transistor cells, each transistor cell comprising a drain region of the first conductivity type, a drift region of the first conductivity type on the drain region, a body region of a second conductivity type, that opposes the first conductivity type, on the drift region and a source region of the first conductivity type on the body region, a gate electrode, and the trench with the conductive member. The conductive member provides a field plate.

In some embodiments, the gate electrode is arranged in a gate trench and is electrically insulated from the semiconductor substrate by an electrically insulating layer formed in the gate trench. The electrically insulating layer lines the trench and may have a greater thickness on the base than on the side wall of the gate trench. In other embodiments, the gate electrode is a planar gate and arranged on a gate dielectric layer that is arranged on the first major surface of the semiconductor substrate.

The gate trench and its gate electrode may have an elongate stripe-like shape. In some embodiments, the gate trench and its gate electrode extend substantially parallel to elongate strip-like trenches with an elongate strip-like field plate. One gate trench may be arranged between neighbouring ones of the elongate stripe-like trenches.

In embodiments, in which the trenches including a field plate are columnar trenches, each comprising a columnar field plate, the gate trenches and the gate electrode may be elongate and stripe-like and be arranged between neighbouring ones of the columnar trenches.

In some embodiments, the semiconductor substrate is formed of silicon, for example monocrystalline or epitaxial silicon, the isolating member is formed of silicon dioxide, the conductive member is formed of polysilicon and the sealing layer is formed of silicon dioxide.

In an exemplary embodiment, a method of producing a cavity in a trench comprises providing a semiconductor substrate having a first major surface, one or more trenches formed in the first major surface and having a base and a side wall extending from the base to the first major surface, sacrificial material lining the base and the side wall of at least one trench of the one or more trenches and a conductive member arranged in the at least one trench and spaced apart from the base and the side wall of the at least one trench by the sacrificial material, removing the sacrificial material from between a side face of the conductive member and the side wall of the at least one trench and removing at least a portion of the sacrificial material from peripheral regions of the base of the at least one trench such that a peripheral edge of the lower face of the conductive member overhangs a gap and such that a central portion of the lower face of the conductive member is supported by a remaining pillar of the sacrificial material that extends between the base of the at least one trench and the lower surface of the conductive member, and depositing a sealing layer onto the first major surface and forming an enclosed cavity in the at least one trench.

In some embodiments, the sacrificial material is at least partially removed by wet etching and/or plasma etching and/or gas chemistry.

In some embodiments, the sacrificial material is removed from between the side face of the conductive member and the sidewall of the at least one trench by wet etching followed by plasma etching to remove the sacrificial material from under the peripheral edge of the lower surface of the conductive member.

In some embodiments, the method further comprises, after removing the sacrificial material, forming a lining on the base and side walls of the at least one trench, side faces of the pillar of the sacrificial material and exposed surfaces of the conductive member.

In some embodiments, the semiconductor substrate comprises a first conductivity type and a plurality of transistor cells, each transistor cell comprising a drain region of the first conductivity type, a drift region of the first conductivity type on the drain region, a body region of the second conductivity type that opposes the first conductivity type on the drift region and a source region of the first conductivity type on the body region, a gate electrode, and the at least one trench with the conductive member. The conductive member provides a field plate.

In some embodiments, the gate electrode is arranged in a gate trench and is electrically insulated from the semiconductor substrate by an electrically insulating layer formed in the gate trench. In other embodiments, the gate electrode is a planar gate and arranged on a gate dielectric layer that is arranged on the first major surface of the semiconductor substrate.

In some embodiments, the at least one trench is an elongate stripe trench. An elongate trench has a length in a plane parallel to the first major surface that is greater than its depth in the substrate, that is its depth perpendicular to the first major surface. A plurality of elongate stripe-like trenches may be provided that extend substantially parallel to one another.

In some embodiments, the at least one trench is a columnar trench. A columnar trench may also be called a needle trench or a specular trench. A columnar trench has a small or narrow circumference or width in proportion to its height / depth in the substrate, that is its height/depth perpendicular to the first major surface. A columnar trench may have an octagonal, circular, square, hexagonal and shape in plan view. The columnar trenches and consequently the field plate positioned in the trench may be arranged in a regular square grid array of rows and columns, or an offset rows or a hexagonal array, for example.

The gate trench and its gate electrode may have an elongate stripe-like shape and extend substantially parallel to elongate strip-like trenches with an elongate strip-like field plate. One gate trench may be arranged between neighbouring ones of the elongate stripe-like trenches.

In embodiments, in which the trenches including a field plate are columnar trenches, each comprising a columnar field plate, the gate trenches and the gate electrode may be elongate and stripe-like and be arranged between neighbouring ones of the columnar trenches.

In some embodiments, the semiconductor substrate is formed of silicon, for example monocrystalline or epitaxial silicon, the isolating member is formed of silicon dioxide, the conductive member is formed of polysilicon and the sealing layer is formed of silicon dioxide.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a cross-sectional view of a portion of a semiconductor device according to an embodiment.
Figure 2 illustrates a cross-sectional view of a portion of a semiconductor device according to an embodiment.
Figure 3 illustrates a cross-sectional view of a portion of a semiconductor device according to an embodiment.
Figure 4 illustrates a cross-sectional view of a portion of a semiconductor device according to an embodiment.
Figure 5 illustrates a cross-sectional view of a portion of a semiconductor device according to an embodiment.
Figure 6 illustrates a flowchart of a method for fabricating a semiconductor device.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n " means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

In an exemplary embodiment, a transistor device is provided with a trench field plate charge compensation structure in which a cavity and a lower isolating member is used as the electrical isolation between the field plate in the trench and the semiconductor substrate. The breakdown voltage of the transistor device is improved by adjusting the width of the lower isolating member in relation to the width of the field plate such that at least the peripheral edge of the lower end of the field plate is located within the cavity and is exposed from the material of the lower isolating member. The lower isolating member provides a supporting pillar that improves the electromechanical stability of the field plate during operation of the transistor device.

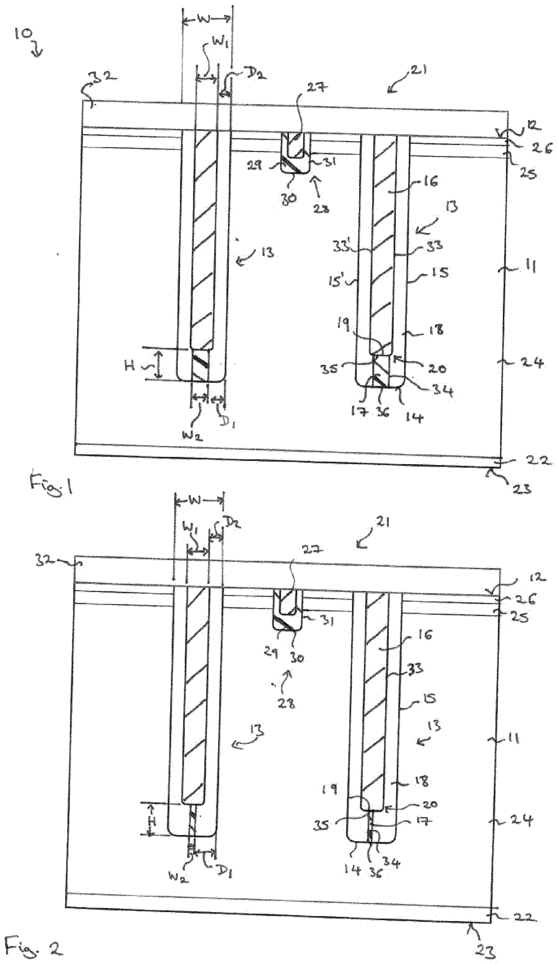

Figure 1 illustrates a cross-sectional view of a portion of a semiconductor device 10 according to an embodiment.

The semiconductor device 10 comprises a semiconductor substrate 11 which has a first major surface 12. The semiconductor substrate 11 may be formed of silicon, for example, a monocrystalline silicon substrate or an epitaxial silicon layer. One or more trenches 13 are formed in the first major surface 12. Each trench 13 has a base 14 and sidewall 15 which extends from the base 14 to the first major surface 12. A conductive member 16 is arranged in each trench 13 and is spaced apart from the base 14 of the trench 13 by a lower electrically isolating member 17 and is spaced apart from the sidewall 15 of the trench 13 by an enclosed cavity 18 which is located within the trench 13. The enclosed cavity 18 provides a void and together with the lower isolating member 17 electrically insulates the electrically conductive member 16 from the semiconductor substrate 11.

In the portion of the semiconductor substrate 11 illustrated in figure 1, two trenches 13 having substantially the same structure are shown. The semiconductor device 10 may have one or more further trenches, which are not illustrated in figure 1, which may have the same structure or a different structure. For example, one or more further trenches having the same structure may be positioned in an edge termination structure and not form part of the active device structure.

The conductive member 16 has a lower face 19 and peripheral edge 20 which is formed between the lower face 19 and the sidewall 15. A central portion of the lower face 19 of the conductive member 16 is in contact with the lower isolating member 17. The peripheral edge 20 of the lower face 19 of the conductive member 16 is exposed from the lower isolating member 17 and is located in the empty cavity 18.

The peripheral edge 20 of the conductive member 16 may have a rounded or curved contour. The entire curved contour of the peripheral edge 20 is located in the empty cavity 18 and is not in contact with the lower isolating member 17.

In some embodiments, the lower face 19 of the conductive member 16 has a rounded form. The periphery of the rounded form is located in the cavity 18 and is not in contact with the lower isolating member 17.

The trench 13 comprising the conductive member 16 may be a columnar trench 13, also known as a needle trench or spicular trench 13, which has a cross-sectional area that is smaller than its height, i.e. depth of the base from the first major surface 12. In these embodiments, the conductive member 16 also has a columnar shape. The columnar trench may have different lateral shapes in plan view. If the columnar trench 13 is circular in plan view it has a single continuous side wall 15. The conductive member 16 is spaced apart from the continuous side wall 15 of the columnar trench by the cavity 18. The cavity 18 can be thought has having a substantially tubular-type volume. If the columnar trench 13 has a square or hexagonal or octagonal shape in plan view, it has a four or six or eight side wall sections, respectively, that extend at an angle to one another. The conductive member 16 is spaced apart from all of the sections of side wall 15 of such a columnar trench 13 by the cavity 18. In the drawings opposing side faces 33, 33' of the conductive member 16 are spaced apart from respective opposing portions of the side wall 15, 15' of the trench 13 by the cavity 18.

Alternatively, the trench 13 may have an elongate stripe-like form in which the length, i.e. the longest direction of the trench 13, is greater than its depth into the semiconductor substrate 11 from the first major surface. The length of the elongate trench 13 extends into the plane of the drawing. In these embodiments, the conductive member 16 also has an elongate strip-like shape. The elongate trench 13 may be substantially rectangular in plan view and comprise a plurality of side wall sections that are arranged substantially perpendicularly to one another. The conductive member 16 is spaced apart from all of the sections of side wall 15 of an elongate striped trench 13 by the cavity 18. Opposing side face sections 33, 33' of the conductive member are spaced apart from respective opposing side wall sections 15, 15' of the trench 13 by the cavity 18.

The cross-sectional structure of the trench 13 and conductive member 16 shown in figures 1 to 5 is the same irrespective of whether the trench 13 and conductive member 16 are columnar or stripe-like in plan view.

The lower isolating member 17 has a lower face 36 that is in contact with the base 14 of the trench 13 and an upper surface 35 that is in contact with the lower face 19 of the conductive member 16 so that the lower isolating member 17 provides a support pillar for supporting the position of the lower end of the conductive member 16 within the trench 13. The lower isolating member 17 is arranged intermediate the lower face 19 of the conductive member 16 and, consequently, intermediate and within the area of the lower face 19 of the field plate 16. Thus, the peripheral edge 20 of the lower face 19 and, in some embodiments, a peripheral edge region, e.g. a peripheral ring, of the lower face 19 is uncovered by the lower isolating member 17 and in contact with the cavity 18. The lower isolating member 17 is also arranged intermediate and within the area of the base 14 of the trench 13. A peripheral region, e.g. a peripheral ring, of the base 14 of the trench is also exposed from the lower isolating member and positioned in the cavity 18. Consequently, the lower isolating member 17 is spaced apart from the peripheral edge 20 formed between the lower face 19 and the sidewall 13 of the conductive member 16 by a portion of the cavity 18. The peripheral edge of the upper face 35 of the lower isolating member 17 is spaced apart from the peripheral edge 20 of the conductive member 17 by a portion of the cavity 18. The conductive member 16 therefore protrudes outwardly from the upper surface 35 of the lower isolating member 17 in directions extending parallel to the first major surface 12.

The cavity 18 is bounded by the side wall 15 and peripheral edge region of the base 14 of the trench 13, the side face 34 of the isolating member 17, the exposed peripheral region 20 of the lower face 19 and the side face 33 of the conductive member 17 and the sealing layer 32.

In the embodiment described with reference to and illustrated in figure 1, the semiconductor device 10 comprises a transistor device having a plurality of transistor cells 21. The semiconductor substrate 11 comprises a first conductivity type. Each transistor cell 21 comprises a drain region 22 of the first conductivity type which may be arranged at a second major surface 23 of the semiconductor substrate 11, the second major surface 23 opposing the first major surface 12, a drift region 24 of the first conductivity type which is arranged on the drain region 22 and a body region 25 of a second conductivity type that opposes the first conductivity type. The body region 25 is arranged on the drift region 24. The transistor cells 21 each further comprise a source region 26 of the first conductivity type which is arranged on the body region 25. For example, if the first conductivity type is n-type, the second conductivity type is p-type or vice versa. The drain region 22 and source region 26 are more highly doped than the drift region 24.

Each of the transistor cells 21 further comprises a gate electrode 27 and one of the trenches 13 including a conductive member 16. In embodiments in which the semiconductor substrate 11 provides a transistor device, the conductive member 16 provides a field plate and may be electrically coupled to source potential or ground potential. In some embodiments, such as that illustrated in figure 1, the gate electrode 27 is arranged in a gate trench 28 which extends into the semiconductor substrate 11 from the first major surface 12. The gate trench 28 has a base 30 and side walls 31 which extend from the base 30 to the first major surface 12. The gate trench 28 may have an elongate stripe-like form. The gate electrode 27 located in the gate trench 28 is electrically isolated from the semiconductor substrate 11 by a gate dielectric 29 which lines the base 30 and sidewalls 31 of the gate trench 28.

In other embodiments, which are not illustrated in the drawings, the gate electrode 27 is a planar that is arranged on the first major surface 12 and electrically insulated from the semiconductor substrate 11 by a planar gate dielectric layer 29 that is arranged on the first major surface 12.

In some embodiments, a sealing layer 32 is arranged on the first major surface 12 which extends over the trenches 13 which comprise the field plate 16. The sealing layer 32 assists in sealing and enclosing cavity 18 to form a void that is located within the trench 13. In some embodiments, the sealing layer 32 also extends over the gate trench 28 and may form part of an interlayer dielectric structure of a metallization structure formed on the first major surface 12. The metallization structure may be used to electrically connect the transistor cells 21 to one another.

In other embodiments, the conductive member 16 within the trench 13 provides a resistor or a capacitor. In some embodiments, the semiconductor device 10 includes one or more trenches 13 in which the conductive member provides a field plate and one or more trenches 13 in which the conductive member provides a resistor or capacitor.

The conductive member 16 comprises a side face 33 which extends from its lower face 19 to the first major surface 12. In some embodiments, the side face 33 extends substantially perpendicularly to the first major surface 12 of the semiconductor substrate 11 and substantially perpendicularly to its lower face 19. In some embodiments, the conductive member 16 has a tapering form and is wider at the first major surface 12 than at the lower face 19.

The lower isolating member 17 has a side face 34 that extends from the lower face 36 that is in contact with the base 14 of the trench 13 to the upper face 35 that is in contact with the lower face 19 of the conductive member 16. In some embodiments, the side face 34 of the lower isolating member 17 extends substantially perpendicularly to the lower face 36 and substantially perpendicularly to the base 14 of the trench 13 and substantially perpendicularly to its upper face 35 and to the lower face 19 of the conductive member 16.

The cavity 18 is a sealed and enclosed empty space or void and may be filled with a vacuum and/or may comprise gases of the environment present when the cavity 18 was sealed. The lower insulating member 17 is formed of solid-state material, for example an oxide or nitride, such as silicon oxide or silicon nitride. In some embodiments, the lower isolating member 17 may include two or more sublayers which may have the same or differing composition, for example a silicon nitride layer and the silicon oxide layer. The conductive member 16 may be formed of polysilicon.

The lower isolating member 17 has a maximum height H and a maximum width W₂. The minimum width W₂ of the lower isolating member 17 is less than the maximum width W₁ of the field plate 16 so that the peripheral region 20 of the field plate 16 is exposed from the lower isolating member 17. The difference between W₂ and W₁ is greater than that arising from processing variations, for e.g. (W₁-W₂)/W₁×100 is at least 10%. The height H and width W₂ of the lower isolating member 17 may vary relative to the width W₁ and area of the lower face 19 of the field plate 16.

The minimum distance between the sidewall 15 of the trench 13 and the sidewall 34 of the lower isolating member 17 is D₁. The maximum spacing between the sidewall 15 of the trench 13 and the sidewall 33 of the field plate 16 is D₂. The distance D₁ is greater than the distance D₂ so that the peripheral edge 20 of the lower face 19 of the field plate 16 is not in contact with the lower isolating member 17 but overhangs the side face of the isolating member 17 and is located within the cavity 18. The difference between D₁ and D₂ is greater than that arising from process variations so that D₁ ≥ 1.1 D₂. A peripheral ring of the lower face 19 of the field plate is exposed from the isolating member 17. A peripheral ring of the base 14 of the trench 13 is also exposed from the isolating member 17.

This arrangement of the cavity 18 and isolating member 17 between the conductive member 16 and the semiconductor substrate 11 provides improved electrical isolation and has the technical effect of increasing the breakdown voltage of the transistor device. Power transistor devices with field plates as compensation structures enable a low on state resistance, Ron. It is also desirable to reduce the area, A, and reduce the parameter Ron × A. The conductive material 16 within the trenches 13 is electrically isolated from the semiconductor substrate 11 by the use of a cavity 18 which has a lower dielectric constant than material such as silicon dioxide. The arrangement described herein uses a supporting pillar formed from the lower isolation member 17 in order to improve the electromechanical stability of the field plate 16, for example during operation of the transistor device. The lower isolation member 17 provides a mechanical anchoring of the lower end of the field plate 16, with the base 14 of the trench 13 and provides mechanical stabilisation of the field plate 16. Since the position of the field plate 16 within the trench 13 is stabilised by means of the lower isolating member 17, the transistor device is more reliable.

Surprisingly, the width of the isolating member 17 in relation to the width of the conductive member 16 has been found to influence the breakdown voltage of the transistor device. In order to increase the breakdown voltage, this relationship is adjusted such that at least the peripheral edge 20, for example the peripheral edge region of the lower face 19 of the conductive member 16, is located within the cavity 18 and is exposed from the material of the lower isolating member 17.

In some embodiments, such as that illustrated in figure 1, the spacing between the lower face 19 of the conductive member 16 and the base 14 of the trench 13 is greater than the spacing D₂ between the side face 33 of the conductive member 16 and the sidewall 15 of the trench 13. In these embodiments, the height H is at least 1.1 D₂ and therefore greater than typical process variations.

The spacing D₂ between the side face 33 of the field plate 16 and the sidewall 15 of the trench 13 may be substantially constant over the entire height of the side face 33 of the conductive of the field plate 16. By substantially constant, this means that the variation in the distance D₂ is less than ± 10%, preferably less than 5% of D₂. The trench 13 has a width W.

Figure 2 illustrates a cross-sectional view of a portion of a semiconductor device 10 according to an embodiment which differs from that illustrated in figure 1 in that the width W₂ of the lower isolating member 17 is reduced compared to the width W₁ of the field plate 16. In some embodiments, the difference between the maximum width W₁ of the field plate 16 and the maximum width W₂ of the lower isolating member 17 is greater than 10%. In some embodiments, 15% ≤ (W₁-W₂)/W₁×100 ≤ 80% or 20% ≤ (W₁-W₂)/W₁×100 ≤ 60%.

Consequently, the spacing D₁ between the side face 34 of the lower isolating member 17 and the side wall 15 of the trench is greater than that of the embodiment illustrated in figure 1 and the difference between the spacing D1 and the spacing D2 between the side wall 33 of the conductive member 16 and the side wall of the trench 13 is greater than that of the embodiment illustrated in figure 1. A larger peripheral region 20 of the lower face of the conductive member 16 is uncovered by the lower isolating member 17 than in the embodiment illustrated in figure 1.

The minimum distance D₁ₘᵢₙ between the side face 34 of the isolating member 17 and the side wall 15 of the trench 13 is greater than the maximum distance D₂ₘₐₓ between the side face 33 of the conductive member 16 and the side wall 15 of the trench 13 so that the minimum distance D₁ₘᵢₙ is at least 10% greater than the maximum distance D₂ₘₐₓ, i.e. D₁ₘᵢₙ is greater or equal to 1.1 D₂ₘₐₓ.

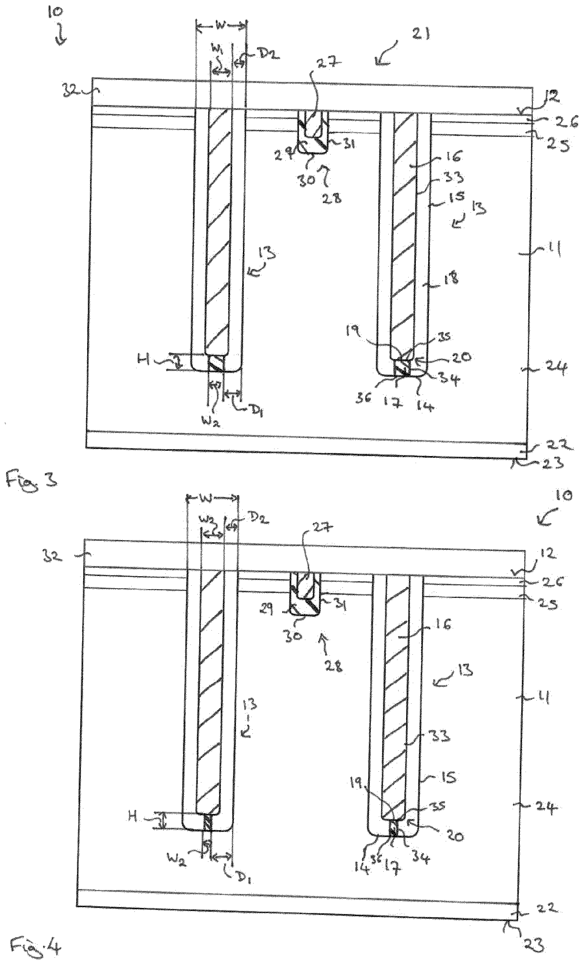

Figure 3 illustrates a cross-sectional view of a portion of a semiconductor device 10 according to an embodiment. The semiconductor device 10 differs from that illustrated in figure 1 in the relationship between the height H of the lower isolating member 17 and the spacing D₂ between the side face 33 of the field plate 16 and the sidewall 15 of the trench 13. In the embodiment illustrated in figure 3, the height H of the lower isolating member 17 and therefore the spacing between the base 14 of the trench 13 and the lower face 19 of the field plate 16 is substantially the same as the spacing D₂ between the sidewall 15 of the trench 13 and the side face 33 of the field plate 16. i.e. H is substantially equal to D₂. In some embodiments, the cavity 18 has a substantially constant or uniform width adjacent the sidewall 15 and base 14 of the trench 13.

Similar to the embodiments described with reference to figures 1 and 2, the spacing between the side face 33 and the lower face 19 of the field plate 16 from the semiconductor material of the semiconductor substrate 11 is substantially uniform. In other words, H = D₂ or H = ± 10% of D₂ and lies within process variations. The spacing D₁ between the side face 34 of the lower isolating member 17 and the sidewall 15 of the trench 13 is, however, greater than the distance D₂ and the height H. The difference (D1-D2) is greater than 10% of D₂ and consequently at least 10% of H.

The spacing D₂ between the side face 33 of the field plate 16 and the sidewall 15 of the trench 13 may be substantially constant over the entire height of the side face 33 of the conductive of the field plate 16. By substantially constant, this means that the variation in the distance D₂ is less than ± 10%, preferably less than 5% of D₂. The trench 13 has a width W.

The minimum distance D₁ₘᵢₙ between the side face 34 of the isolating member 17 and the side wall 15 of the trench 13 is greater than the maximum distance D₂ₘₐₓ between the side face 33 of the conductive member 16 and the side wall 15 of the trench 13 so that the minimum distance D₁ₘᵢₙ is at least 10% greater than the maximum distance D₂ₘₐₓ, i.e. D₁ₘᵢₙ is greater or equal to 1.1 D₂ₘₐₓ.

Figure 4 illustrates a cross-sectional view of a portion of a semiconductor device 10 according to an embodiment in which the relationship between the height H and D₂ which is similar to that illustrated in figure 3 and differs from that illustrated in figure 3 in the width W₂ of the lower isolating member 17 and in the relationship between the width W₂ of the lower isolating member 17 and the width W₁ of the conductive member 16. In this embodiment, the width W₂ is smaller than the semiconductor device 10 illustrated in figure 3. The width W of the trench 13 is the same and the width W₂ of the conductive member is the same as the semiconductor device of figure 3. The difference between the width W₂ of the lower isolating member 17 and the width W₁ of the field plate 16 is greater. As a result, the spacing D₁ between the side face 34 of the lower isolating member 17 and the side wall 15 of the trench 13 is larger than in figure 3 and the difference between the spacing D₁ between the side face 34 of the lower isolating member 17 and the sidewall 15 of the trench 13 and the spacing D₂ between the side face 33 of the field plate 16 and the sidewall 15 the trench 13, i.e. (D₁-D₂), is greater than that of the embodiment illustrated in figure 3.

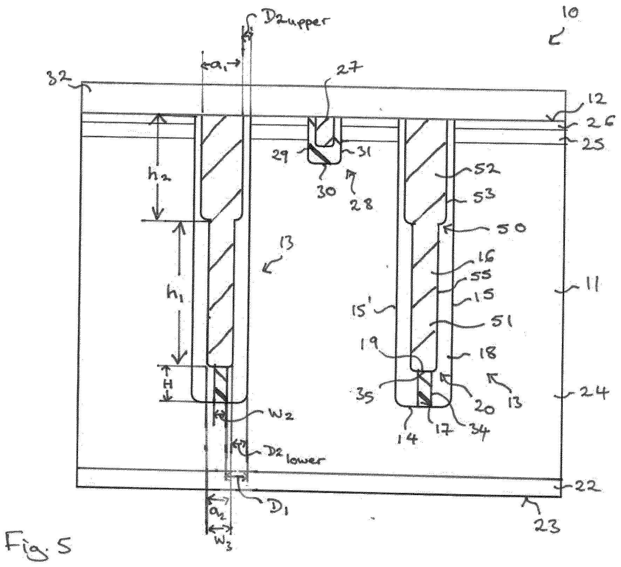

Figure 5 illustrates a cross-sectional view of a portion of a semiconductor device according to an embodiment. in this embodiment, the conductive member 16 comprises a step 50 in its side face such that it has a lower first portion 51 which has a width a₂ which is less than the width a1 of an upper second portion 52. The width a₁ of the upper second portion 52 is at least 10% greater than the width a1 of the lower first portion 51. For example, a₂ ≥ 1.1a₁. The trench 13 comprises a sidewall 15 which extends relative to the first major surface 12, for example substantially perpendicularly, such that the width of the cavity 18 formed between the sidewall 15 of the trench 13 and between the side face 33 of the conductive member 16 varies along the height of the trench.

In some embodiments, such as that illustrated in figure 5, the transition between the wider upper second portion 52 and the lower first portion 51 is abrupt and forms the step 50. The upper portion 52 protrudes laterally outwards from the lower portion 51 in directions substantially parallel to the first major surface 12 such that the step 50 has the form of a ledge facing towards the base 14 of the trench 13 and extending substantially parallel to the first major surface 12.

The first portion has a height h₁ and the second portion has a height h₂. In some embodiments, the side face of the first and second portion 50, 51 extends substantially perpendicularly to the first major surface 12. In some embodiments, the width a₂ is substantially the same over the height h₁ and the width a₂ is substantially the same over the height h₂.

The cavity 18 has a spacing D₂ᵤₚₚₑᵣ between the side face 53 of the second portion 52 and the sidewall 15 of the trench 13 which is less than the spacing D_{2lower} between the side face 55 of the lower first portion 51 and the sidewall 15 of the trench 13. In some embodiments, the difference (D₂ᵤₚₚₑᵣ - D_{2lower})/ D₂ᵤₚₚₑᵣ is greater than 10% and therefore greater than processing variations. D_{2lower} is less than the spacing D₁ between the side face 34 of the lower isolating member 17 and the side wall 15 of the trench 13 and greater than a difference resulting from process variations. In some embodiments, the difference (D₁ - D_{2lower})/D₁ is greater than 10% and therefore greater than processing variations.

In other embodiments, the transition between the wider upper portion of the conductive member 16 and the narrower lower portion of the conductive member 16 and is more gradual and in some embodiments, the conductive member 16 may have a tapering shape which tapers from a wider upper portion positioned adjacent the first major surface 12 in a direction towards the base 14 of the trench 13. The trench 13 comprises a sidewall 15 which extends relative to the first major surface 12, for example substantially perpendicularly, such that the width of the cavity 18 formed between the sidewall 15 of the trench 13 and between the side face 33 of the conductive member 16 varies along the height of the trench 13, e.g. increases from the top to the bottom of the trench 13. The cavity 18 has a spacing D₂ᵤₚₚₑᵣ between the side face 53 of the second portion 52 and the sidewall 15 of the trench 13 which is less than the spacing D_{2lower} between the side face 55 of the lower first portion 51 and the sidewall 15 of the trench 13. In some embodiments, the difference (D₂ᵤₚₚₑᵣ - D_{2lower})/ D₂ᵤₚₚₑᵣ is greater than 10% and therefore greater than processing variations. D_{2lower} is less than the spacing D₁ between the side face 34 of the lower isolating member 17 and the side wall 15 of the trench 13 and greater than a difference resulting from process variations. In some embodiments, the difference (D₁-D_{2lower})/D₁ is greater than 10% and therefore greater than processing variations.

For embodiments in which the conductive member 16 has an upper portion 52 that is wider than a lower portion 51, the width W₃ of the lower face 19 of the conductive member 16 is greater than the width W₂ of the lower isolating member 17 such that at least the peripheral edge of the lower face is uncovered by the lower isolating member 17 and is positioned in the cavity 18. The relationships between W₂ and W₁ described herein also apply to analogously to the relationship between W₃ and W₁.

In some embodiments, the minimum width a₂ of the lower portion 51 over its entire height h₂ is less than the maximum width W₂ of the lower isolating member 17 such that at least the peripheral edge of the lower face is uncovered by the lower isolating member 17 and is positioned in the cavity 18. The relationships between W₂ and W₁ described herein also apply to analogously to the relationship between a₂ and W₁.

In the embodiment illustrated in figure 5, the height H of the lower isolating member 17 is greater than the spacing D_{2lower}. However, in other embodiments, the height H may be substantially the same as the spacing D_{2lower}. Again, the ratio of the W₂ of the isolating member and the width a₂ of the lower first portion 51 of the conductive member 16 may be varied. In all embodiments, the peripheral edge of the lower surface 19 of the conductive member 16 is not in direct contact with the lower isolating member 17 but is located within the cavity 18.

The arrangement of a conductive member 16 which has a greater width in an upper portion 52 compared to a lower portion 51 and a corresponding cavity 18 located in the trench 15 that has a narrower width between the side face 33 of the conductive member 16 and the side wall 15 of the trench in the upper portion of the trench 13 compared to the width of the cavity 18 between the side face 33 of the conductive member 16 and the side wall 15 of the trench in the lower portion of the trench 13 enable the doping concentration of the drift region 24 to be increased in regions laterally adjacent the upper portion of the trench 13. This can be used to enable a further reduction is Ron × Area of the transistor device.

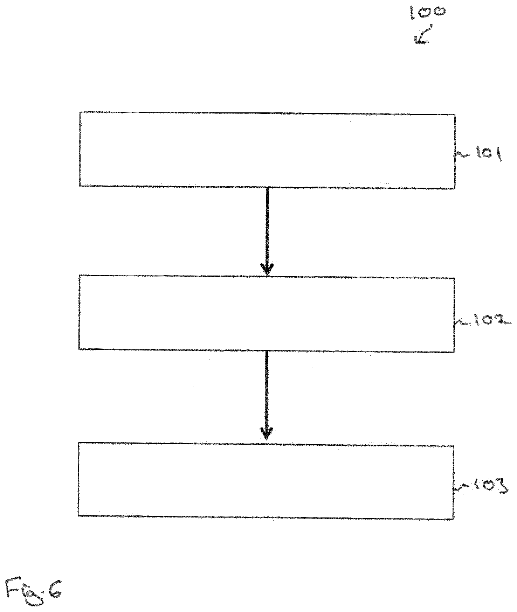

Figure 6 illustrates a flowchart 100 of a method for fabricating a semiconductor device. The method may be used for fabricating the semiconductor device described with reference to figures 1 to 5.

In block 101, a semiconductor substrate is provided. The semiconductor substrate has a first major surface, one or more trenches formed in the first major surface and having a base and a side wall extending from the base to the first major surface, sacrificial material lining the base and the side wall of at least one trench of the one or more trenches and a conductive member arranged in the at least one trench and spaced apart from the base and the side wall of the at least one trench by the sacrificial material.

The sacrificial material may be selected so as to be selectably removable, e.g. selectably etchable over the material of the conductive member 16. For example, the sacrificial material may be silicon oxide and the conductive member formed of polysilicon, for example.

In some embodiments, the semiconductor substrate comprises a first conductivity type and a plurality of transistor cells, each transistor cell comprising a drain region of the first conductivity type, a drift region of the first conductivity type on the drain region, a body region of the second conductivity type that opposes the first conductivity type on the drift region and a source region of the first conductivity type on the body region, a gate electrode, and the at least one trench with the conductive member, wherein the conductive member provides a field plate.

In some embodiments, the gate electrode is arranged in a gate trench and is electrically insulated from the semiconductor substrate by an electrically insulating layer formed in the gate trench.

In block 102, the sacrificial material is removed from between a side face of the conductive member and the side wall of the at least one trench and at least a portion of the sacrificial material is removed from peripheral regions of the base of the at least one trench such that a peripheral edge of the lower face of the conductive member overhangs a gap and such that a central portion of the lower face of the conductive member is supported by a remaining pillar of the sacrificial material that extends between the base of the at least one trench and the lower surface of the conductive member.

The sacrificial material may be removed by wet etching and/or plasma etching and/or gas chemistry. In some embodiments, the sacrificial material is removed from between the side face of the conductive member and the sidewall of the at least one trench by wet etching followed by plasma etching to remove the sacrificial material from under the peripheral edge of the lower surface of the conductive member. This combination of etching processes may be used to such that the sacrificial material is etched substantially in the vertical direction in the first process to remove the sacrificial material between the side face of the conductive member and the second wall of the trench and is etch substantially horizontally in the second etch process to remove the sacrificial material from under the lower face of the conductive member and form the support pillar-shaped lower isolating member between the base of the trench and the lower face of the conductive member.

In block 103, a sealing layer is deposited onto the first major surface and forming an enclosed cavity in the at least one trench. The sealing layer may be formed of silicon oxide, for example.

In some embodiments, after removing the sacrificial material, the method further comprises forming a lining on the base and side walls of the at least one trench, side faces of the pillar of the sacrificial material and exposed surfaces of the conductive member. The lining may be a thin continuous layer and may be formed of SiO₂.

To summarise, a semiconductor device is provided that comprising a conductive member in a trench which is electrically insulated from the semiconductor substrate, in which the trench is formed, by an enclosed cavity or void within the trench and a lower isolating member that also mechanically supports the lower end of the conductive member within the trench. The peripheral edge of the lower face of the conductive member is exposed from the lower isolating member and forms part of the wall that defines the cavity. This combination of the cavity and lower isolating member provides an improved breakdown voltage and improved electromechanical stability of the conductive member.

In an exemplary embodiment, the conductive member provides a field plate of a transistor device. The breakdown voltage of the transistor device is improved by adjusting the width of the lower isolating member in relation to the width of the field plate such that at least the peripheral edge of the lower end of the field plate is exposed from the material of the lower isolating member and is located within the cavity. The lower isolating member provides a supporting pillar that improves the electromechanical stability of the field plate during operation of the transistor device.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device, comprising:
a semiconductor substrate having a first major surface;
one or more trenches formed in the first major surface and having a base and a side wall extending from the base to the first major surface;
a conductive member arranged in at least one trench of the one or more trenches and spaced apart from the base of the at least one trench by a lower isolating member and from the side wall of the at least one trench by an enclosed cavity located in the at least one trench,
wherein a peripheral edge of the lower face of the conductive member is located in the cavity and a central portion of the lower face is in contact with the lower isolating member.

2. A semiconductor device according to claim 1, wherein the upper surface of the lower isolating member is in contact with the lower face of the conductive member and the isolating member provides a support pillar that is arranged intermediate the area of the lower face of the conductive member and the area of the trench base and is spaced apart from the peripheral edge of the conductive member by a portion of the cavity.

3. A semiconductor device according to claim 2, wherein the conductive member protrudes outwardly from the upper surface of the lower isolating member in directions parallel to the first major surface.

4. A semiconductor device according to any one of claims 1 to 3, wherein the lower isolating member has a side face and the conductive member has a side face, wherein the minimum spacing between the side face of the lower isolating member and the side wall of the at least one trench, D₁, is greater than the maximum spacing between the side face of the conductive member and the side wall of the at least one trench, D₂

5. A semiconductor device according to claim 4, wherein the isolating member has a height H from the base to its upper surface, wherein H > D₂.

6. A semiconductor device according to any one of claims 1 to 5, wherein the conductive member comprises a first maximum width W₁ and the isolating member has a second maximum width W₂, wherein (W₁-W₂)/W₁×100 is greater than 10%.

7. A semiconductor device according to any one of claims 1 to 6, wherein the spacing between the side face of the conductive member and the sidewall of the at least one trench is greater in a first portion of the at least one trench than in a second portion of the at least one trench.

8. A semiconductor device according to claim 7, wherein the side wall of the conductive member comprises a step such that an upper portion of the conductive member has a width a₁ that is greater than a width a₂ of a lower portion of the conductive member and such that an upper portion of the cavity has a width D₂ᵤₚₚₑᵣ that is smaller than a width D_{2lower} of a lower portion of the cavity.

9. A semiconductor device according to any one of claims 1 to 8, further comprising a sealing layer that extends between the side wall of the at least one trench and the side face of the conductive member and that seals the cavity.

10. A semiconductor device according to any one of clams 1 to 9, wherein the at least one trench is an elongate trench or a columnar trench.

11. A semiconductor device according to any one of claims 1 to 10, wherein the semiconductor substrate comprises a first conductivity type and a plurality of transistor cells, each transistor cell comprising a drain region of the first conductivity type, a drift region of the first conductivity type on the drain region, a body region of a second conductivity type, that opposes the first conductivity type, on the drift region and a source region of the first conductivity type on the body region, a gate electrode, and the trench with the conductive member, wherein the conductive member provides a field plate.

12. A method of producing a cavity in a trench, the method comprising:
providing a semiconductor substrate having a first major surface, one or more trenches formed in the first major surface and having a base and a side wall extending from the base to the first major surface, sacrificial material lining the base and the side wall of at least one trench of the one or more trenches and a conductive member arranged in the at least one trench and spaced apart from the base and the side wall of the at least one trench by the sacrificial material;
removing the sacrificial material from between a side face of the conductive member and the side wall of the at least one trench and removing at least a portion of the sacrificial material from peripheral regions of the base of the at least one trench such that a peripheral edge of the lower face of the conductive member overhangs a gap and such that a central portion of the lower face of the conductive member is supported by a remaining pillar of the sacrificial material that extends between the base of the at least one trench and the lower surface of the conductive member.
depositing a sealing layer onto the first major surface and forming an enclosed cavity in the at least one trench.

13. A method according to claim 12, wherein the sacrificial material is at least partially removed by wet etching and/or plasma etching and/or gas chemistry.

14. A method according to claim 13, wherein the sacrificial material is removed from between the side face of the conductive member and the sidewall of the at least one trench by wet etching followed by plasma etching to remove the sacrificial material from under the peripheral edge of the lower surface of the conductive member.

15. A method according to any one of claims 12 to 14, wherein the semiconductor substrate comprises a first conductivity type and a plurality of transistor cells, each transistor cell comprising a drain region of the first conductivity type, a drift region of the first conductivity type on the drain region, a body region of the second conductivity type that opposes the first conductivity type on the drift region and a source region of the first conductivity type on the body region, a gate electrode, and the at least one trench with the conductive member, wherein the conductive member provides a field plate.
